# EUROPEAN PATENT SPECIFICATION

(11) **EP 3 656 002 B1**
(45) Date of publication and mention of the grant of the patent: **14.04.2021**
(21) Application number: 18740857.0
(22) Date of filing: 20.07.2018
(51) Int. Cl.: H01L 41/09, H01L 41/04, H01L 41/193

(54) **ACTUATOR STRUCTURE AND ACTUATION METHOD THEREOF**
AKTORSTRUKTUR UND BETÄTIGUNGSVERFAHREN DAFÜR
STRUCTURE D'ACTIONNEUR, ET PROCÉDÉ D'ACTIONNEMENT ASSOCIÉ

(30) Priority: 20.07.2017 EP 17182292
(43) Date of publication of application: 27.05.2020
(73) Proprietor: Koninklijke Philips N.V., 5656 AG Eindhoven (NL)
(72) Inventor: VAN DEN ENDE, Daan, Anton, 5656 AE Eindhoven (NL); HAKKENS, Franciscus, Johannes, Gerardus, 5656 AE Eindhoven (NL); HENDRIKS, Cornelis, Petrus, 5656 AE Eindhoven (NL); HILGERS, Achim, 5656 AE Eindhoven (NL); HOVENKAMP, Ronald, Antonie, 5656 AE Eindhoven (NL); JOHNSON, Mark, Thomas, 5656 AE Eindhoven (NL)
(74) Representative: Philips Intellectual Property & Standards
(86) International application number: PCT/EP2018/069737
(87) International publication number: WO 2019/016362

(56) References cited:
- EP-A1- 0 124 250
- JP-A- H05 284 600

## Description

### FIELD OF THE INVENTION

This invention relates to an actuator structure comprising an electroactive material, and a method for controlling the same.

### BACKGROUND OF THE INVENTION

EP 0124250 discloses a displacement generation device which comprises: a piezoelectric displacement element for receiving an externally applied drive voltage and for generating a displacement in response to the drive voltage; and an electrical element connected in a series with said piezoelectric displacement element and having a temperature coefficient of an electrostatic capacitance which has a polarity opposite to that of the electrostatic capacitance of said piezoelectric displacement element. The electrical element properly changes the drive voltage applied to the piezoelectric displacement element when the electrostatic capacitance of the piezoelectric displacement element changes in accordance with a change in temperature, thereby compensating for the displacement of the piezoelectric displacement element which is caused by the change in temperature.

JP H05 284600 discloses that, to improve the temperature dependence of a piezoelectric ceramic element, a temperature compensating capacitor Cs is connected in series to the piezoelectric ceramic which may be obtained by sintering lead titanate, for example.

Electroactive materials (EAMs) are a class of materials within the field of electrically responsive materials. When implemented in an actuation device, subjecting an EAM to an electrical drive signal can make it change in size and/or shape. This effect can be used for actuation and sensing purposes. There exist inorganic and organic EAMs. One particular kind of organic EAM is that of electroactive polymers (EAPs).

Electroactive polymers (EAPs) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 1MHz, most typically below 20 kHz.

Known electroactive material based actuators experience significant thermal drift. Thermal drift means uncontrolled drift or variation in the actuation displacement of the actuator, caused by changes in environmental temperature. It occurs because electroactive material expands with increasing temperature which causes non-negligible shifts in the actuation displacement of the actuator.

Thermal drift renders the actuators inaccurate, especially when applied in non-conditioned environments, for instance when incorporated into medical probes which, upon entry to the human body, become subject to significant increases in temperature.

It is possible to overcome thermal drift using active compensation means, wherein changes in temperature are actively detected, and variations to applied current or voltage controlled in response to compensate. However, such active feedback mechanisms render the actuator costly and complex.

Means for overcoming the difficulties of thermal drift in EAM based actuators are therefore desired which are less costly and complex than known means.

### SUMMARY OF THE INVENTION

The invention is defined by the independent claims; the dependent claims define advantageous embodiments.

The invention is based on countering thermal variation (i.e. thermally-induced variation) in actuation displacement through implementation of a means which effects, through some passive physical mechanism, a modification of the drive current or voltage supplied to the active layer structure, of a magnitude being dependent upon temperature. Passive means may include 'integral', in the sense that the means is based upon some intrinsic physical or electrical property pertaining to the means, rather than for instance rely upon external sensors to implement a closed loop control operation. Passive is used in contrast to active, by which is meant actively gathering data or measurements from e.g. external sensors, and adjusting current or voltage accordingly. By passive may be meant 'one-step', i.e. relying upon a single integral physical or electrical mechanism, rather than for instance multi-step mechanisms such as where e.g. external measurements are taken and active logic 'decisions' taken in response.

By using a passive compensation means, thermal drift may be compensated in an operationally simple manner. Manufacture is rendered simpler and cheaper, since the number of parts required is fewer than for an active compensation means. Reliability may also be improved due to the reduced number of parts and reduced complexity.

The passive compensation means comprises in particular a multi-layer temperature dependent capacitor structure. The rate of change of capacitance with temperature may be such as to provide a temperature-dependent boost in supplied voltage or current to the active layer structure of a magnitude configured to compensate for temperature-dependent variations in actuation displacement.

The actuator structure comprises a passive carrier layer structure coupled to the active layer structure. The carrier layer structure is a backing layer structure. Passive means non electrically responsive, in contrast to the active layer structure. The passive carrier layer structure should be sufficiently flexible to withstand mechanical strain caused by bending of the actuator.

The carrier layer structure is adapted to form the multi-layer capacitor structure. Thus, layers of the passive layer structure effectively form the layers of the temperature-dependent capacitor structure, or vice versa. This minimizes form factor and footprint of the actuator structure, by integrating the passive layer structure with the passive compensation means.

Furthermore, since in this case the temperature-dependent capacitor is kept in close proximity to the active layer structure (by being coupled to it), it is also ensured that the temperature variations at each are very similar. Preferably, the active layer structure and capacitor layer structure are thermally coupled to one another or otherwise in thermal communication with one another.

Integrating the passive compensation means into the backing structure carries advantages including reduced form factor and closer temperature coupling of the compensation means and the active layer. However, for many electroactive materials, such as electroactive polymers, a large capacitance is needed in order to adjust the exhibited electrical deformation by a sufficient amount to counter the thermal deformation. This is in part because these materials have a high electrical permittivity. Providing sufficient capacitance in the small form factor of the backing layer structure poses a problem.

The invention overcomes this problem by providing a multi-layer capacitor structure. By using a multi-layer capacitor structure, a larger capacitance can be built up, using the different layers in combination to provide a large overall capacitance. The layer structure may provide multiple individual capacitor layers for example, which can be connected together, e.g. in parallel, to provide a large overall capacitance from a relatively small area.

The passive carrier layer structure may in examples comprise a layer stack of thin films of polymer material, for example with metallized internal electrodes and/or thin layers of ceramic material, for example with metallized internal electrodes. Suitable ceramic materials, to enable forming of the multilayer capacitor structure and to provide the necessary structural properties for the carrier layer function include for example Barium Titanate, Strontium Titanate, Bismuth Titanate, Sodium Titanate. Other ceramic materials which might be included in addition to capacitor structure forming layers include for instance Yttrium Oxide or Niobium Oxide or combinations of these and similar materials as will be apparent to the skilled person.

Ceramics may be particularly suitable for use when the structure of the passive carrier layer stack is such that the ceramic layers are on or close to the neutral bending axis of the actuator structure, where bending stresses are negligible. This may limit the thickness of the ceramic layers to around 10 micrometers, which corresponds to only several layers (2-4 depending on the material). Standard polymer capacitor materials (such as polypropylene, polyesters and Polyphenylene sulfide) are more capable of withstanding mechanical strain which is important when used as a backing.

The active layer structure may exhibit a thermal deformation as a function of temperature, and wherein the passive compensation means modifies said voltage or current as a function of temperature at a rate such as to cause a consequent variation in electrical deformation which counters said thermal deformation. The deformation may be in-plane deformation. Where the active layer structure is clamped or comprises a rigid backing, this may be transformed into out-of-plane deformation.

The multilayer capacitor structure may be connected in series with the electroactive material of the active layer structure and arranged for receiving the drive voltage or current to be supplied to active layer structure.

The capacitor structure may form a drive voltage input circuit for the actuator structure, such that current or voltage applied to the active layer structure passes through the component, and the capacitor structure may operate electrically upon the drive voltage or current to passively regulate the supplied voltage in dependence upon temperature.

In accordance with one set of examples, the passive compensation means may further include a temperature-dependent resistor. This may be electrically connected in series with the capacitor structure for example to provide an additional source of temperature-dependent impedance. The rate of change of resistance with temperature may be such as to reduce supplied voltage or current to the active layer structure at a rate configured, in combination with the temperature-dependent capacitor structure, to compensate for temperature-dependent variations in actuation displacement.

According to one or more examples, the multiple layers of the capacitor structure may form a plurality of separate capacitors. There are preferably connected in parallel. For example, each layer of the multi-layer structure may form a separate capacitor. Alternatively, two or more layers may in some cases form one capacitor.

At least two of the plurality of capacitors formed by the capacitor structure in this case may have differing capacitances. In this way the structure can be precisely tuned to a particular desired capacitance level, i.e. to tune the level of the capacitance-temperature curve.

In accordance with a further set of embodiments, the passive compensation means may be further provided by a material property of one or more of the material layers of the active layer structure. In this way, material of the active layer structure itself exhibits some intrinsic variation in an electrical property or parameter as a function of temperature which induces a variation in the current or voltage exhibited across it.

In one set of examples, the material property may be an electrical permittivity which varies as a function of temperature. Electrical permittivity of a material is a measure of a resistance encountered when forming an electric field across the material. The lower the permittivity, the lower the displacement field established across the material in response to an applied external electric field.

In examples, the electrical permittivity may decrease as a function of increasing temperature. For a fixed applied drive voltage, this would lead to a decrease in actual internally experienced displacement field across the material as a function of increasing temperature. This may counter thermal expansion.

According to one or more embodiments, the actuator structure may include a capacitance adjustment means arranged to supply a controllable bias voltage to the multi-layer capacitor structure formed by the backing layer structure. This allows adjusting of a capacitance exhibited by the multi-layer capacitor structure in dependence upon the applied bias voltage. Optionally, the controller may provide the capacitance adjustment means. Alternatively, a separate voltage supply means may be provided to apply the controllable bias.

The permittivity of a capacitor (and also permittivity gradient with temperature) is voltage dependent (and capacitance is naturally dependent upon the permittivity). Hence by providing a controllable bias voltage, the capacitance behavior can be adjusted.

A capacitance adjustment means allows a level of capacitance of the capacitor structure to be calibrated to achieve optimal temperature compensation in a given scenario. For example, the exhibited level of temperature deformation of the active layer may depend upon the circumstances, or may vary over time as properties of the actuator structure change. It may also be hard to know in advance precisely the level and behavior of the actuation drift. The capacitance compensation means allows the level to be set in operation, or to be adjusted for different scenarios. This increases flexibility.

The applied bias voltage may be configured to be adjustable based on user input commands for example, or may be configured automatically, for instance based on sensing or monitoring a level of thermal variation in actuation displacement, and adjusting the bias level so that the compensation provided counters drift in actuation displacement. A combination of both may be provided.

In some cases, the bias voltage may be adjusted in dependence upon temperature. The bias voltage-temperature relationship may in this case be configured so as to compensate for the thermal variation in actuation displacement. A temperature sensor may be provided to facilitate this functionality.

The capacitance compensation means may in any example be configured to adjust the level of the supplied bias voltage such that the capacitance exhibited by the capacitor structure as a function of temperature modifies the current or voltage at a rate such as to cause a consequent variation in electrical deformation which counters the thermal variation in actuation displacement.

In accordance with one or more embodiments, the actuator structure may further comprise a controller adapted to control provision of electrical stimulation to the active layer structure to control deformation of the layer structure, the electrical stimulation being provided via said passive compensation means. The controller may provide a drive voltage or current in accordance with a desired degree of actuation. The drive voltage is applied via said passive compensation means. The capacitor structure may be connected in series with an electrical output of the controller for example to thereby define a passively compensated control circuit. This may be further connected in series with any other components or elements of the passive compensation means.

The active layer structure may include or be arranged in co-operation with an electrode arrangement for applying an electric field or current to electroactive material of the material layers of the active layer structure.

In accordance with one or more set of embodiments, the controller may be adapted in use to provide a persistent electrical bias to the active layer structure to stimulate partial deformation of the active layer structure. This electrical bias may be of a magnitude to drive the active layer structure to a fully actuated state. Controlled deformation (actuation) is then effected by reducing drive voltage or current commensurately with the desired degree of actuation displacement.

For relaxor ferroelectric EAP materials (a class of electroactive material) in particular, when in a fully actuated state, the material is in an all-trans state. This state has a lower thermal expansion co-efficient than other states. It is the intrinsic thermal expansion of the EAP material with temperature that leads to the thermal drift in actuation displacement. Hence by keeping the electroactive material in the fully actuated state, the initially exhibited thermal drift is reduced. In combination with the passive compensation means, this achieves even more efficient and effective mitigation of thermal drift, and/or requires less alteration of the applied drive current by the compensation means, improving efficiency.

In accordance with any embodiment, the active layer structure may be configured to exhibit a bending bias in a first direction in the absence of electrical deformation of the active layer structure, and is configured to exhibit a bending bias in an opposing direction upon electrical deformation.

An advantage of this configuration is that any residual thermal drift which does still occur despite the mitigating effects of the passive compensation means may always be compensated for to bring the actuator structure back to a reference or 'flat' shape by applying a small degree of drive voltage. Whichever direction the residual thermal drift acts in, it will be possible to return the actuator structure back to a flat shape, either using electrical deformation (in the case of drift toward the pre-bending direction) or using the bending bias itself (in the case of drift counter to the pre-bending direction).

Optionally, a controller is provided and adapted in use to provide a persistent electrical bias to the active layer structure to partially counter said bending bias in the first direction. In this case, the actuator structure is brought to a reference state at a first reference temperature. Any temperature change is substantially compensated for by the passive compensation means. However, any residual drift which remains can be compensated by simply reducing or increasing the drive voltage slightly to bring the actuator structure back to its reference configuration.

There is hence provided in these configurations a high degree of flexibility in adjusting for temperature-induced actuation displacement drift.

In accordance with any embodiment, the carrier layer structure may include one or more pre-stressed material layers, and wherein the carrier layer structure exhibits an elasticity which varies positively with temperature. This means that with increasing temperature, the carrier (backing) layer becomes more flexible enabling the (positive or negative) thermal expansion of the active layer structure to be accommodated, and thereby avoiding or mitigating thermal drift.

In particular examples for instance, at least the active layer structure may exhibit a thermal expansion which varies negatively with temperature. In this case, with increasing temperature, the active layer structure will tend to contract, while the carrier layer structure becomes more flexible, thereby allowing some of its pre-stress to release in-plane, leading also to a consequent slight contraction. Hence the two layers contract in parallel with one another and their respective effects upon one another are effectively nullified or cancelled out. Thermal drift is thereby averted. Note that for this to be effective in this example, the carrier layer structure should be pre-stressed with a compressive stress such that as elasticity increases, the released pre-stress lead to contraction.

In combination with the passive compensation means, this adaptation ensures even more robust and efficient mitigation of thermally-induced actuation displacement drift.

Note that by 'pre-stressed' is typically meant adapted (for instance pre-treated) to exhibit a persistent in-plane stress.

Examples in accordance with a further aspect of the invention provide an actuation method comprising controlling electrical stimulation of an actuator structure, the structure comprising: an active layer structure comprising one or more material layers, each including an electroactive material deformable in response to electrical stimulation, and a passive carrier layer structure coupled to the active layer structure; and the method comprising: providing electrical stimulation to the active layer structure, wherein a current or voltage of the electrical stimulation is pre-modified as a function of temperature by a passive compensation means to thereby compensate for thermal variation in actuation displacement of the actuator structure, wherein the passive compensation means comprises a multi-layer temperature-dependent capacitor structure, and wherein said passive carrier layer structure is adapted to form said capacitor structure.

The active layer structure may exhibit a thermal deformation as a function of temperature, and wherein said passive compensation means is adapted to modify said voltage or current as a function of temperature at a rate such as to cause a consequent variation in electrical deformation which counters the thermal deformation.

### BRIEF DESCRIPTION OF THE DRAWINGS

Examples of the invention will now be described in detail with reference to the accompanying drawings, in which:
Figs. 1 and 2 show two possible operating modes for an EAP device;
Fig. 3 shows a graph illustrating change in thermal drift with temperature;
Fig. 4 illustrates a basic EAM actuator clamped at one edge;
Fig. 5 shows an example actuator structure in accordance with one or more embodiments of the invention;
Fig. 6 shows a graph illustrating electrical permittivity of three materials as a function of (inverse) temperature;
Fig. 7 shows graphs illustrating electrical permittivity of a range of electroactive material and filler composites as a function of temperature;
Fig. 8 schematically depicts an example actuator structure comprising a hybrid carrier layer structure for providing temperature-dependent permittivity and temperature-dependent capacitance;
Fig. 9 shows three material states of an example EAP material;
Fig. 10 shows variation in thermal drift rate of a relaxor ferroelectric EAP as a function of increasing applied drive voltage;
Fig. 11 illustrates a possible implementation of an example actuator structure in accordance with one or more embodiments of the invention; and
Fig. 12 illustrates a further possible implementation of an example actuator structure in accordance with one or more embodiments of the invention.

### DETAILED DESCRIPTION OF THE EMBODIMENTS

The invention provides an actuator structure comprising an electroactive material-based active layer structure which exhibits an intrinsic variation in actuation displacement as a function of temperature. A passive compensation means is provided to modify a current or voltage of an electrical stimulation applied to the active layer structure as a function of temperature such as to compensate for said thermally-induced variation in actuation displacement. The passive compensation means comprises a multi-layer temperature-dependent capacitor structure, and is formed by layers of a passive carrier layer structure provided coupled to the active layer structure.

The invention makes use of Electroactive materials (EAMs) which, as noted above are a class of materials within the field of electrically responsive materials. One emerging class within EAMs in particular is that of electroactive polymers (EAPs). As noted, EAPs can work as sensors or actuators and can easily be manufactured into various shapes allowing easy integration into a large variety of systems.

Devices using electroactive polymers can be subdivided into field-driven and ionic-driven materials.

Examples of field-driven EAPs include Piezoelectric polymers, Electrostrictive polymers (such as PVDF based relaxor polymers) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

Field-driven EAPs are actuated by an electric field through direct electromechanical coupling. They usually require high fields (volts per meter) but low currents. Polymer layers are usually thin to keep the driving voltage as low as possible.

Ionic EAPs are activated by an electrically induced transport of ions and/or solvent. They usually require low voltages but high currents. They require a liquid/gel electrolyte medium (although some material systems can also operate using solid electrolytes).

Both classes of EAP have multiple family members, each having their own advantages and disadvantages.

A first notable subclass of field-driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field-driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of field-driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrrole (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Altering the charge on the carbon atoms results in a change of C-C bond length. As a result, expansion and contraction of single CNT can be observed.

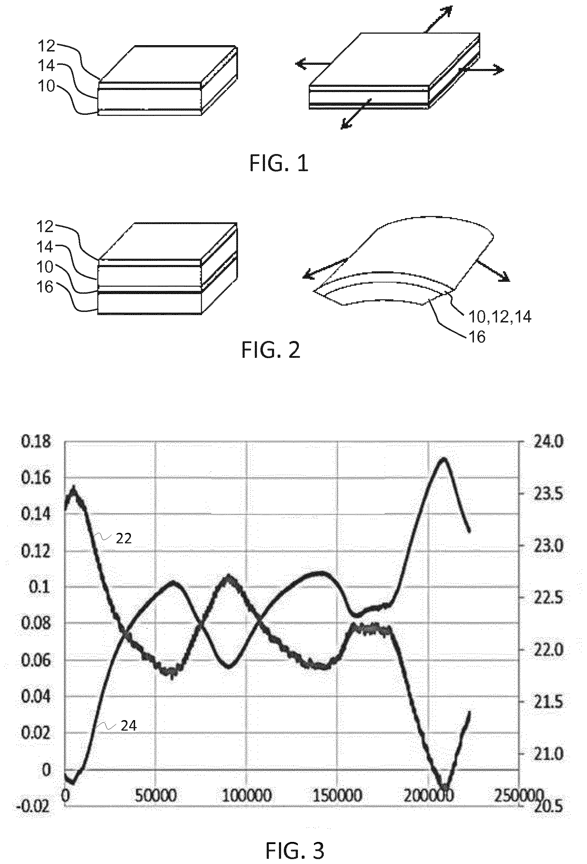

Figs. 1 and 2 show two possible operating modes for an EAP device.

The device comprises an electroactive polymer layer 14 sandwiched between electrodes 10, 12 on opposite sides of the electroactive polymer layer 14.

Fig. 1 shows a device which is not clamped. A voltage is used to cause the electroactive polymer layer to expand in all directions as shown.

Fig. 2 shows a device which is designed so that the expansion arises only in one direction. The device is supported by a carrier layer 16. A voltage is used to cause the electroactive polymer layer to curve or bow.

Together, the electrodes, electroactive polymer layer, and carrier may be considered to constitute the overall electroactive polymer structure.

The nature of this movement for example arises from the interaction between the active layer, which expands when actuated, and the passive carrier layer. To obtain the asymmetric curving around an axis as shown, molecular orientation (film stretching) may for example be applied, forcing the movement in one direction.

The expansion in one direction may result from the asymmetry in the EAP polymer, or it may result from asymmetry in the properties of the carrier layer, or a combination of both.

An electroactive polymer structure as described above may be used both for actuation and for sensing. The most prominent sensing mechanisms are based on force measurements and strain detection. Dielectric elastomers, for example, can be easily stretched by an external force. By putting a low voltage on the sensor, the strain can be measured as a function of voltage (the voltage is a function of the area).

Another way of sensing with field-driven systems is measuring the capacitance-change directly or measuring changes in electrode resistance as a function of strain.

Piezoelectric and electrostrictive polymer sensors can generate an electric charge in response to applied mechanical stress (given that the amount of crystallinity is high enough to generate a detectable charge). Conjugated polymers can make use of the piezo-ionic effect (mechanical stress leads to exertion of ions). CNTs experience a change of charge on the CNT surface when exposed to stress, which can be measured. It has also been shown that the resistance of CNTs change when in contact with gaseous molecules (e.g. O₂, NO₂), making CNTs usable as gas detectors.

In the detailed examples which follow, responsive material elements comprising EAP material are provided. However, this is by way of illustration only, and in all cases it is to be understood that in the embodiments described, the EAP material element may be replaced by a different variety of responsive material element (stimulated by a suitable stimulus) without altering the general concept, functioning or achieved general advantages of the invention.

The invention is based on compensating for thermal drift in actuator displacement. By thermal drift is meant uncontrolled drift or variation in the actuation displacement of the actuator in the absence of any electrical stimulation, caused by changes in environmental temperature. It occurs because electroactive material expands with increasing temperature which causes non-negligible shifts in the actuation displacement of the actuator.

By way of example, Fig. 3 shows the displacement (y-axis, left; mm) over time (x-axis; seconds) measured for a free standing relaxor ferroelectric electroactive polymer actuator as environmental temperature (y-axis, right; °C) is varied. Line 22 shows variation in displacement, while line 24 shows variation in temperature.

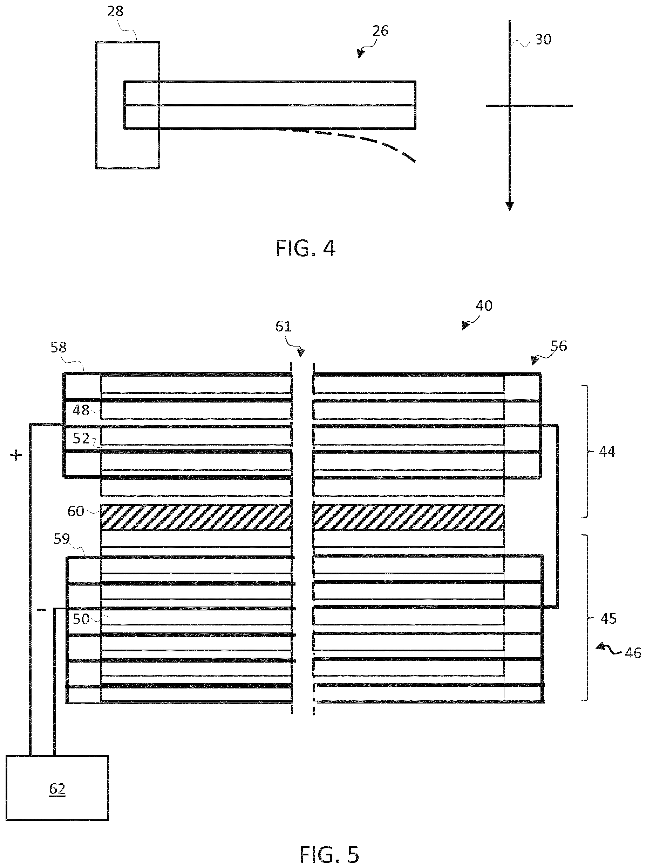

No actuation voltage is applied. The displacement was measured for an actuator clamped at one edge, and measured along an axis running perpendicular to the plane of the layers of the actuator at a distance of 3 mm from the clamp. This is illustrated schematically in Fig. 4, which shows the EAP actuator 26 clamped at one edge by clamp element 28, and the displacement axis 30 along which displacement was measured, located 3 mm from the clamp member.

Returning to Fig. 3, over time the environment temperature fluctuates, resulting in a bending of the actuator. As a result of increasing temperature the actuator displacement increases (the actuator bends upwards). A temperature fluctuation of approximately 3°C results in a deflection (drift) of approximately 0.15 mm. This is large relative to a typical actuation deflection, which is generally between 0-2 mm. For precision actuation applications (where much finer degrees of displacement are required) such a drift is especially large, and may even exceed the total desired displacement, or the desired change in displacement.

For relaxor ferroelectric EAP materials, the ideal operating temperature range for actuation is limited around the ferroelectric-paraelectric (F-P) transition temperature. In typical situations, the environmental temperature is no more than +/-10 degrees around this transition temperature.

For dielectric elastomer actuators the operating temperature must be higher than the glass transition temperature. For ionic actuators, the temperature is limited by the diffusion properties of the membrane layer and in case of wet systems (those making use of a liquid/gel electrolyte medium) ultimately by the boiling point of the liquid. Should the ion-carrying liquid boil, gas bubbles would be generated which would inhibit effective functionality, and may even result in explosion due to thermal expansion.

For precision applications, the actuator may suffer from drift if the temperature fluctuates during actuation. This is especially problematic for actuators that require long term precision actuation (e.g. holding a fixed displacement position or dynamically shifting between very small displacement intervals, such as sensor position corrections) under varying temperature conditions, for instance for EAPs arranged to operate in proximity to functional components which may heat up during use.

For precision applications, the actuator may be calibrated using a calibration technique. However, the calibration is performed at a certain fixed temperature. If the environmental temperature in use is different from the calibration temperature, the actuator may have an offset in actuation.

For instance, for in-body applications, the environmental temperature may vary from 36.5 - 37.5 °C for healthy subjects and up to 39 °C for patients with fever. These temperature differences can create an offset of 0.05-0.15 mm for the actuator in the example above.

For this reason, the invention proposes a compensation means for countering thermally-induced drift in actuation displacement. This invention proposes in particular using passive electrical compensation means to achieve this effect. In accordance with embodiments, a compensation means is implemented having the effect of passively altering a supplied drive current or voltage as a function of temperature to compensate for the thermal drift. The resulting actuator structure may be used in temperature environments which are subject to change during actuation.

The passive compensation means comprises at least a multi-layer temperature dependent capacitor structure. This temperature dependent capacitor structure is in particular formed by layers of a backing layer structure of the actuator structure itself. This provides a particularly compact and efficient arrangement. The capacitor structure may be connected in series with the electroactive material of the active layer structure and modifies the current or voltage supplied to it in dependence upon temperature.

An example of such an arrangement, in accordance with one or more embodiments of the invention, is schematically depicted in Fig. 5.

An actuator structure 40 comprises an active part 44 and a backing (carrier) part 45. The active part consists of an active layer structure comprising a plurality of stacked material layers 48, each comprising an electroactive polymer material. The layers may be formed entirely of electroactive polymer, i.e. forming a body of EAP material, or may comprise EAP as one constituent. In the illustrated example, the active layer comprises a structure or stack of four EAP-based material layers 48, however in other examples a different number of layers may be provided, where this could be as few as just a single layer.

The active layer structure is configured in electrical communication with an electrode arrangement 56 comprising a plurality of electrodes 58 arranged sandwiching each of the material layers 48 of the active layer structure. The active layer structure typically comprises electrode material incorporated within the structure itself, positioned extending either side of each of the material layers. The electrode arrangement is in this case partially formed by these material layers and partially formed by a set of electrical connections extending from each of the electrode material layers to a controller 62. The controller 62 is adapted to control stimulation of the material layers by applying electrical stimuli to the active layer structure via the series connected capacitor backing structure 46.

The (non-actuating) backing or carrier part 45 consists of a layer structure comprising a plurality of material layers 50. The material layers are configured to together form one or more temperature dependent capacitors.

In particular, there is provided a multilayer capacitor configuration, known from the field of multilayer capacitors. Each material layer 50 comprises a dielectric material, situated between two electrical electrodes 59. Multiple layers are connected in parallel to increase the capacitance. The parallel capacitor arrangement thus effectively forms a single overall composite capacitor having total capacitance equal to the sum of the capacitances of the individual layers.

In other examples, the collection of layers may together form a single capacitor. In this case, a single pair of electrodes may be provided.

This backing capacitor structure is electrically connected in series with the active layer structure 44. Drive voltages or currents are applied to the active layer structure via the capacitor backing, as indicated by the positive and negative connection points illustrated in Fig. 5.

The backing structure 46 thereby provides a passive compensation means 46 for the actuator structure 40. The temperature dependent capacitance of the capacitor(s) formed by the backing layer structure 45 is such as to vary an overall voltage supplied to the active layer structure 44 as a function of temperature. The capacitor structure operates upon drive voltages received from an electrically connected controller 62 and acts to modify them as a function of temperature. The rate of induced voltage or current change with temperature is such as to induce in the active layer structure a corresponding change in actuation displacement (in a reverse direction) which matches the intrinsic rate of actuation-displacement drift with temperature of the electroactive materials of the active layer structure. In this way thermal drift may be compensated for.

An electrical isolation layer 60 is provided disposed between the active layer structure 44 and the backing layer structure 45 to electrically isolate them from one another. This ensures that electrical communication between the two structures is only via the series electrical connection provided between their respective electrode arrangements 56, 59.

Although Fig. 5 shows a vertical gap 61 running through a center of the actuator member 42, this is merely for schematic illustrative purposes, to indicate that the actuator member is wider than is shown in Fig. 5. The layers of the actuator member in fact continue unbroken across the entire horizontal width of the actuator member, from one side to the other.

As shown, in the particular example of Fig. 5, the backing layer structure 46 comprises a greater number of material layers 50 than the active layer structure (seven layers in this case, rather than four). In further examples however, the backing layer structure may comprise fewer material layers than the active layer structure.

The active layer structure 44 optionally further includes bonding material(s) 52 between adjacent layers 48 to couple or secure the multiple layers to one another.

The layers of the active layer structure may form a multi-layer stack of very thin layers. This keeps driving voltages low, so long as electrodes are provided either side of each layer such that each can be stimulated directly.

As noted above, to form the capacitor arrangement, the backing layer structure 46 may also comprise an electrode arrangement. In this way, each material layer may form a separate capacitor these then being connected in parallel. In this case an arrangement of multiple electrodes is provided (as in the example of Fig. 5), arranged sandwiching each material layer.

The material layers may be formed, in examples, of any soft or compliant polymer dielectric material, or, in further examples, solid (e.g. dielectric) particles may be used embedded in a flexible or compliant polymer matrix.

More particularly, the passive carrier layer structure may in examples comprise a layer stack of thin films of polymer material, for example with metallized internal electrodes and/or thin layers of ceramic material, for example with metallized internal electrodes. Suitable ceramic materials to enable forming of the multilayer capacitor structure and to provide the necessary structural properties for the carrier layer function include for example Barium Titanate, Strontium Titanate, Bismuth Titanate, Sodium Titanate. Other ceramic materials which might be included in addition to capacitor structure forming layers include for instance Yttrium Oxide or Niobium Oxide or combinations of these and similar materials as will be apparent to the skilled person.

Ceramics may be particularly suitable for use when the structure of the carrier layer stack is such that the ceramic layers are on or close to the neutral bending axis of the actuator structure, where bending stresses are negligible. This may limit the thickness of the ceramic layers to around 10 micrometers, which corresponds to only several layers (2-4 layers, depending on the material). Standard polymer capacitor materials (such as polypropylene, polyesters and Polyphenylene sulfide) are more capable of withstanding mechanical strain which is important when used as a backing.

By utilizing layers of a backing structure as a temperature-dependent capacitor, the resulting capacitor is disposed in close proximity to the active layer structure. This ensures that the capacitor follows the same temperature fluctuations as the active layer structure with a high degree of precision.

According to one set of embodiments, a temperature-dependent resistor (i.e. thermistor) may also be provided, this forming an additional part of a passive compensation means. This may be connected in series with the capacitor structure for example. The impedances of the two together combine to provide a compound compensation means.

Preferably, a positive temperature coefficient (PTC) thermistor is provided. The temperature dependent resistor in such embodiments is connected in electrical series with the capacitor structure form by the carrier layer structure 45. Drive voltages or currents are supplied to the active layer structure via the temperature dependent resistor. The rate of change of resistance with temperature is such as to impose a modification of drive current or voltage with temperature which offsets or substantially counter any thermal drift in actuation displacement.

The temperature dependent resistor is in this case preferably arranged in strong thermal communication with the electroactive material of the active layer structure, such that temperature fluctuations of the two are in close harmony. In this way, the change in resistance should be such as to compensate the drift (assuming well-matched temperature dependency behavior of the two components).

In accordance with one or more sets of embodiments, the passive compensation means may further be provided by a material property of the active layer structure of the actuator structure, to compensate thermal drift in actuation displacement. In particular, for actuated EAP materials (with the exception of relaxor ferroelectric terpolymers) the electrical characteristics of the active layer structure may be tuned to compensate any thermally induced drift. This electrical characteristic may in examples include the electrical permittivity of the material.

For dielectric elastomer EAPs, the thermal expansion of the EAP (as a function of temperature) is positive, meaning that the EAP expands in-plane with rising temperature. This in-plane expansion leads to the drift in actuation displacement with temperature.

If the permittivity of the elastomer material is such that it decreases as a function of increasing temperature, the effect is that for each unit drive voltage applied, the resulting actuation displacement caused is reduced. Hence, if the (negative) change in permittivity with temperature is tuned appropriately, it can be made to offset or counter (through reduced actuation response of the active layer structure to applied drive voltage) the temperature-induced drift in actuation displacement.

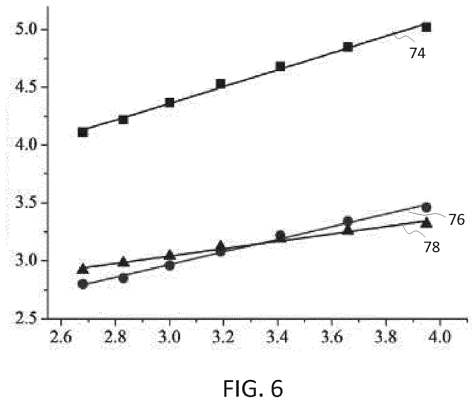

The required negative dependency of permittivity on temperature is exhibited by a number of types of, for instance dielectric elastomer, materials. These include in particular certain acrylics and siloxane rubbers. This is illustrated in Fig. 6 which shows the variation of dielectric constant (y-axis) as a function of (inverse) temperature (x-axis; units 1000/K) for three different example materials. Line 74 shows the dependency for VHB (acrylic), line 76 for Sylgard 186 (silicone elastomer), and line 78 for M-Polypower material. These are all commercially available materials.

As shown, all exhibit a negative permittivity dependence with increasing temperature (shown in Fig. 6 as positive dependency with inverse temperature).

The nature of the temperature dependency of the permittivity of dielectric elastomers can be tuned, in accordance with examples, by adding filler particles, thereby forming a filler-elastomer composite material. By adjusting the ratio of filler material to elastomer material, the permittivity-temperature dependency can be tuned to any of a wide range of different levels. In this way, the permittivity behavior can be tuned so as to exactly compensate the thermal drift behavior of any particular actuator which is desired.

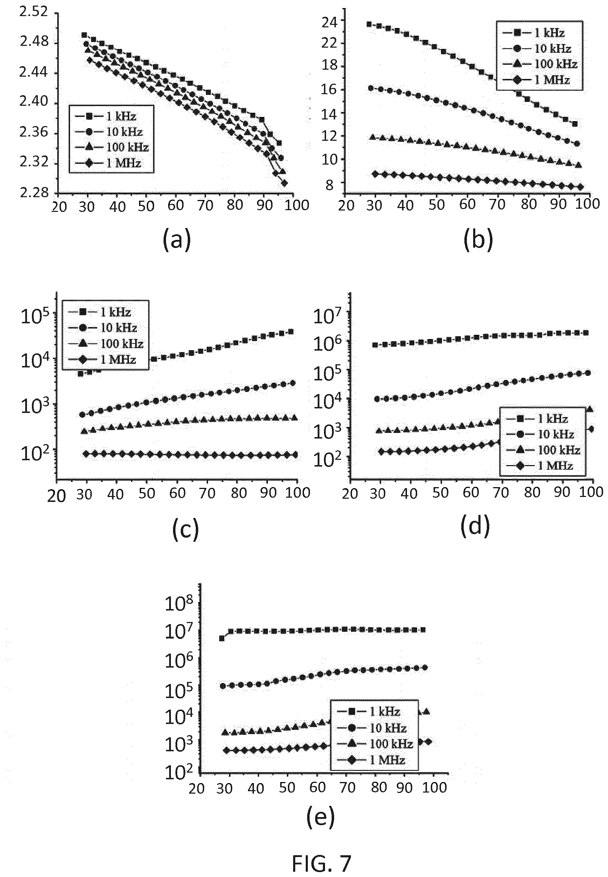

This is illustrated by the graphs of Fig. 7 which show the relation of electric permittivity (y-axis) to temperature (°C) for different AC frequencies, of a set of multiple different PDMS/Carbon Black composites, each comprising a different ratio of PDMS to Carbon black. In each graph, the lines show (from top to bottom) the exhibited relationships at 1kHz drive frequency, 10kHz frequency, 100 kHz and 1 MHz.

Fig. 7(a) shows the relationship for pure PDMS, with no carbon black. As shown, there is a strong negative dependency of permittivity to increasing temperature. Fig. 7(b) shows the relationship for a composite with 90% PDMS, 10% Carbon Black. Here, the dependency is slightly reduced, and more so for higher frequencies. Fig. 7(c) shows the relation for a composite of 80% PDMS, 20% carbon black. Here the dependency is in fact positive for all but the highest drive frequency. The same is true for a composite of 70% PDMS, 30% Carbon Black, shown in Fig. 7(d), although here, the positive dependency is present even at the highest drive frequencies. Fig. 7(e) shows the dependency for a composite of 60% PDMS, 40% Carbon Black. Here, there is a very slight positive dependency for higher drive frequencies, but almost zero dependency at the lowest drive frequency.

It is clear from this therefore, that depending upon the particular thermal drift behavior and rate which is desired to be offset, whether positive or negative, and depending upon the intended drive voltage for the actuator structure, a suitable composite material may be selected exhibiting the required compensatory permittivity variation with temperature to exactly or substantially offset the thermal drift.

In the case that the temperature dependency of permittivity is to be provided for the material layers of the passive carrier layer structure, the material layers and the layer structure must be configured to provide both this functionality and to provide the multi-layer capacitor structure integrated in the carrier layer structure.

Hence, when opposite permittivity-temperature variation in the carrier (or backing) layer structure compared to the active layer structure is to be provided, the material layers of the backing structure will need to be materials capable of withstanding mechanical strain due to actuation and materials exhibiting negative temperature coefficients of permittivity.

Suitable materials in this case include elastomers (such as siloxane or acrylic elastomers - some examples of which were for instance described above in relation to Fig. 6). However, in some cases, these materials may not provide adequate mechanical properties to act as a passive backing (especially when for example relaxor ferroelectric EAP materials are used in the active layer).

Where these EAP materials are used within the active layer, the carrier layer structure may preferably comprise a multilayer stack which includes at least one set of structural layers providing the necessary structural properties and a further set of layers providing the required negative temperature-dependency of permittivity. Preferably only the further set of layers has electrical properties affected by an applied electric field, while the structural polymer layers are not affected by an electric field. In such a configuration, the backing structure provides both adequate mechanical properties as well as the dielectric function that is needed to electrically compensate for the thermal drift of the EAP. The necessary structural properties are resistance to mechanical strain, to permit the backing to provide the required effect of forcing bending when the active layer expands in-plane. The structural layers are therefore preferably resilient layers.

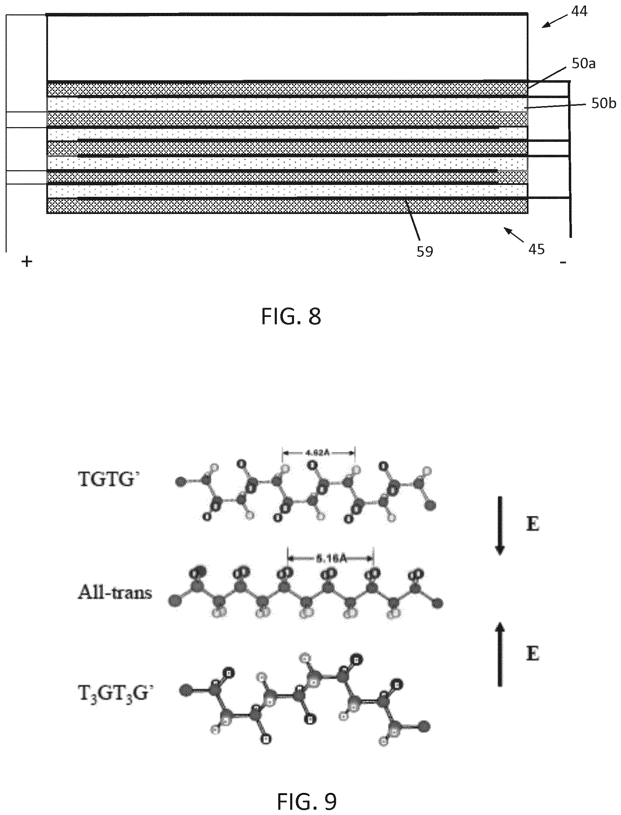

Fig. 8 schematically depicts a cross-sectional view of an example actuator structure incorporating such a hybrid carrier layer structure. The active layer structure 44 is shown as comprising a single layer of EAP material with encompassing electrodes, but the active layer structure may comprise more than one material layer in other examples. The carrier layer structure 45 comprises a first set of material layers 50a for providing flexural resilience, and a second set of material layers 50b for providing negative permittivity-temperature dependency behavior in addition to temperature dependent capacitance behavior. The two sets of material layers are interleaved. An electrode structure is shown. An electrode is disposed between each neighboring pair of material layers. In this example, the electrodes extend only part way across the respective layer. The electrodes extend the majority of the way across the respective layer.

In other examples, the carrier layer structure may comprise one section which provides a negative permittivity-temperature dependency behavior and another neighboring section which provides the multi-layer temperature-dependent capacitor function.

In accordance with any embodiment of the invention, the structural or mechanical properties of the layers of the actuator structure may be adapted such as to provide mechanical based compensation for any residual thermal drift still persisting. In particular, in cases where the active layer structure comprises a field-driven EAP material, it is possible to substantially match the thermal expansion properties of the material with thermally-induced elasticity variations of a backing of the active layer structure such that the two effects may cancel out. In this case, any residual thermal drift not offset by the passive compensation means is countered by the mechanical properties of the layers of the actuator structure.

For instance, for relaxor ferroelectric PVDF-terpolymer materials, the temperature expansion coefficient is negative (i.e. the electroactive material tends to contract with increasing temperature) in most cases before the actuator structure is in the fully actuated position (at which point the mechanical properties of the material temporarily transition). If there is provided a backing layer to the electroactive material layers of the active layer structure (e.g. to induce bending behavior of the active layer structure upon deformation), the backing may be provided pre-stressed and with a stiffness which decreases with temperature (i.e. an elasticity which increases with temperature). In this case, with increasing temperature, the active layer structure will tend to contract, while the backing layer structure becomes more flexible, thereby allowing some of its pre-stress to release in-plane, leading also to a consequent slight contraction. Hence the two layers contract in parallel with one another and their respective effects upon one another are effectively nullified or cancelled out. Thermal drift is thereby avoided. Note that for this to be effective in this example, the backing layer structure should be pre-stressed with a compressive stress such that as elasticity increases, the released pre-stress lead to contraction.

Note that by 'pre-stressed' is typically meant adapted (for instance pre-treated) to exhibit a persistent in-plane stress.

Preferably in this case, the glass transition temperature of the backing material may be equal to the ferroelectric-paraelectric (F-P) transition of the EAP. In this case, the mechanical effect of the reduced stiffness of the backing will largely cancel the unwanted thermal expansion of the EAP. The F-P transition of the EAP material causes the negative thermal expansion, (and consequent thermal drift). Around the glass transition temperature of the backing, the stiffness of the backing reduces significantly. In this case these two effects (expansion of active layer and reduced stiffness of backing) may cancel one another out.

Optionally, the temperature dependence of at least some of the backing layer's material properties may also be tuned to any desired behavior through including suitable combinations of different materials with different mechanical and thermal properties.

In accordance with one or more sets of embodiments, the actuator structure may be driven in a 'reverse-drive' mode, wherein the actuator is kept idle in a fully actuated state (thereby keeping electrical pre-load on the EAP when in use), and wherein any actuation displacement is achieved by lowering the drive voltage temporarily.

An advantage of this mode of driving is that, for relaxor ferroelectric EAP material in particular, the material will be kept in the all-trans state initially, i.e. when idle (see Fig. 9, middle illustrated state). This state has a lower thermal expansion coefficient than the combination of the other two states at the ferroelectric-paraelectric (F-P) transition temperature, which are less stable (note that it is this effect which drives the primary electrical displacement behavior of these EAPs).

The F-P transition temperature is generally the preferred operating temperature for the actuator device (as noted above). It also represents a particularly advantageous temperature for presently considered embodiments in which maintenance of the all-trans state is desired, for the following reasons.

The all-trans state in Fig. 9 can be achieved in both the ferroelectric and paraelectric states. In the ferroelectric phase, the polymer will stay in all-trans state after removal of the electric field. In the paraelectric phase, the polymer will revert back to the TGTG' state when the field is removed. If a (simplifying) assumption is made that electrically-induced strain is proportional to the proportion of the material in the two different states, the overall strain will be greater in the paraelectric phase per applied unit electric field.

However, in the paraelectric state, the all-trans state is harder to achieve (i.e. a greater electric field is required to switch the polymer to the all-trans configuration).

Therefore, around the ferroelectric-paraelectric phase transition there is an optimum in the strain per unit applied electric field.

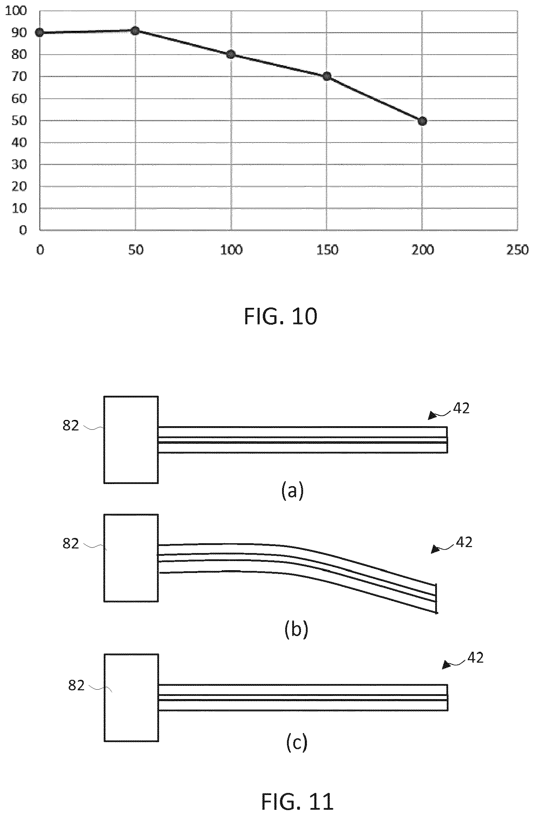

Especially for applications that require relatively small but precise actuations, this 'reverse' driving approach will reduce the thermal expansion effect, because the thermal expansion coefficient (CTE) at 200-250V actuation voltage is lower than the CTE around 0V. This is illustrated by Fig. 10 which shows the rate of change of actuation displacement with temperature (y-axis, units: µm/°C) vs applied drive voltage (x-axis, units: V) for a relaxor ferroelectric EAP. It can be seen that as applied drive voltage increases, the expansion coefficient of the material declines.

Driving the actuator structure in accordance with this mode may therefore further enhance the thermal drift compensation effects of the invention, ensuring that any residual thermal drift not fully countered by the passive compensation means may be further countered by these mechanical effects.

In accordance with any embodiment of the invention, the original shape of the actuator structure may be configured in such a manner that it is always possible to use a portion of the driving signal used for actuation to bring the actuator back into a "reference" (e.g. substantially flat) state - at least within a certain envisioned temperature range of operation.

This may be achieved in particular by configuring the original shape of the actuator such that thermal drift biases the actuator member in an opposing direction to electrical stimulation of the active layer structure. This ensures that any residual thermal drift which does occur in embodiments (i.e. which is not fully compensated by the passive compensation means) may always be corrected manually through partial actuation of the actuator member, to thereby bring the actuator member back to a "reference" (e.g. flat) state.

For example, if it suspected that the actuator device will generally experience increasing temperatures in its particular intended application (e.g. if it is to be used near components which heat up, or to be used or implanted within a body) the parameters of the actuator may be such that the bending upon heating up opposes the bending by actuation.

An example is illustrated schematically in Fig. 11 which shows an example actuator member 42 clamped at one side by clamp element 82. Although a backing layer of the illustrated actuator structure is shown as a single layer, it may be configured as a multi-layer structure.

Fig. 11(a) shows the actuator at a state of zero applied voltage, and temperature T=T₀.

Fig. 11(b) shows the actuator still with zero applied voltage, but wherein the environmental temperature has increased to T=T₀ + ΔT. As a result, a displacement drift has been induced in a downward direction of distance Δd.

Fig. 11(c) shows the actuator now still at temperature T=T₀ + ΔT, but wherein a stimulation voltage ΔV has been applied to the active layer structure. The actuator member is configured such that electrical stimulation of the active layer structure results in an actuation bias in an upward direction. Hence, by applying a small actuation voltage, the thermally-induced displacement drift can be 'corrected' to return the actuator member to an approximately flat reference state.

In accordance with an alternative set of examples, the actuator may be "pre-bent" in such a way that, even the absence of electrical or thermally stimulated deformation, the actuator member is biased in a certain direction. Here again, thermally induced displacement of the actuator can be corrected through application of an electrical stimulation to the active layer structure so as to bring the actuator member back to a reference state. However, an advantage of this embodiment is that it is not necessary to anticipate in which direction thermal drift will bend the actuator. The initial 'pre-bending' bias allows a degree of thermal drift in either direction, while ensuring it is always still possible to bring the actuator back to a normal (e.g. 'flat') position by electrical stimulation.

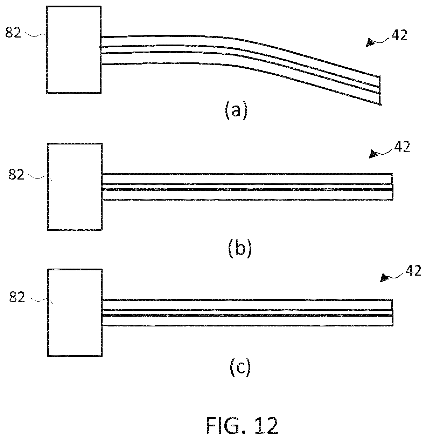

An example is schematically illustrated in Fig. 12, which again shows an example actuator member 42 clamped at one side by clamp element 82. Again, a multi-layer backing may be provided. Fig. 12(a) shows the actuator at a state of zero applied voltage, and temperature T=T₀. As shown, the pre-biasing of the actuator member results in a downward bending in the absence of any applied voltage or thermal expansion.

Fig. 12(b) shows the actuator, still at T=T₀, but wherein a stimulation voltage ΔV has been applied to the active layer structure to thereby bring the actuator member back to a reference state.

Fig. 12(c) on the other hand shows a state in which the environmental temperature has increased to T=T₀+ΔT, therefore inducing a residual actuation drift upwards. In response, the actuation voltage has been reduced correspondingly, such that it is now back at V=0. Hence it can be seen that this embodiment allows for a greater flexibility to accommodate changing environmental temperatures, since actuation voltage may always be applied to a necessary extent to return the actuator member 42 to a reference (e.g. flat) state. Of course, this comes at the cost of slightly smaller useable actuation stroke.

According to one or more embodiments, the actuator structure may include a capacitance adjustment means arranged to supply a controllable bias voltage to the multi-layer capacitor structure 45 formed by the backing layer structure. This allows adjusting of a capacitance exhibited by the multi-layer capacitor structure in dependence upon the applied bias voltage. Optionally, the controller may provide the capacitance adjustment means. Alternatively, a separate voltage supply means may be provided to apply the controllable bias.

The permittivity of a capacitor (and also permittivity gradient with temperature) is voltage dependent (and capacitance is naturally dependent upon the permittivity). Hence by providing a controllable bias voltage, the capacitance behavior can be adjusted.

A capacitance adjustment means allows a level of capacitance of the capacitor structure to be calibrated to achieve optimal temperature compensation in a given scenario. For example, the exhibited level of temperature deformation of the active layer may depend upon the circumstances, or may vary over time as properties of the actuator structure change. It may also be hard to know in advance precisely the level and behavior of the actuation drift. The capacitance compensation means allows the level to be set in operation, or to be adjusted for different scenarios. This increases flexibility.

The applied bias voltage may be configured to be adjustable based on user input commands for example, or may be configured automatically, for instance based on sensing or monitoring a level of thermal variation in actuation displacement, and adjusting the bias level so that the compensation provided counters drift in actuation displacement. A combination of both may be provided. In some cases, the bias voltage may be adjusted in dependence upon temperature, with the bias voltage-temperature relationship configured so as to compensate for the thermal variation in actuation displacement.

The capacitance compensation means may be configured to adjust the level of the supplied bias voltage such that the capacitance exhibited by the capacitor structure as a function of temperature modifies the current or voltage at a rate such as to cause a consequent variation in electrical deformation which counters the thermal variation in actuation displacement.

In practice, this may be implemented in different ways.

According to at least one set of embodiments, the supplied bias voltage on the capacitor structure 45 may be configured to vary in dependence upon temperature (to dynamically follow temperature changes). Dedicated control circuitry may be provided for implementing this functionality. For example, the bias voltage may be applied over a voltage divider, with a thermistor provided as one of the components of the divider. In this way, the applied bias voltage is rendered temperature-dependent. The applied bias voltage that is required for accurate compensation of actuation displacement drift in the working temperature range of the EAP may for example be determined by tracking or calibrating the thermal drift of the actuator with temperature and storing the values in a lookup table. The voltage divider may be tuned so as to exhibit the corresponding bias voltage-temperature variation.

According to at least one set of embodiments, the bias voltage may be regulated by a separate controller. This controller may be configured in different ways. In one set of examples, the controller may be configured to adjust the bias voltage as a function of temperature, the temperature being acquired using a temperature sensor for example.

In other examples, the controller may be configured to adjust the bias voltage in dependence directly upon a sensed temperature-induced variation in the actuator displacement. For example, the capacitance adjustment means may comprise an actuator deformation sensing mechanism. The controller may be arranged to receive an input from this sensing mechanism and to detect any changes in actuation displacement which occur in the absence of any concurrent change in applied actuation drive voltage. If such anomalous deformation changes are detected, the controller may respond by adjusting the bias voltage applied to the capacitor structure so as to induce an actuation displacement change which compensates for the thermally-induced drift. The necessary bias voltages required to induce given changes in displacement may for example be stored in a lookup table and consulted by the controller to determine the correct bias voltage adjustment to compensate for sensed actuation displacement drift.

In cases where a force is acting on the actuator, an additional force sensing mechanism may be provided to enable changes in actuation displacement due to applied force to be identified and isolated from temperature-induced changes.

In the above described embodiments, different embodiments of an actuator structure comprising a passive thermal-drift compensation means in accordance with the invention have been described. All include a carrier layer structure coupled to an active layer structure, and wherein layers of the carrier layer structure form a multi-layer capacitor structure to thereby provide at least part of the compensation means. Further options include the following.

Use in addition of a temperature dependent electrical component exhibiting an electrical parameter that is dependent on temperature and that is utilized to adjust actuation voltage or current to compensate for the drift. This may be connected in series with the multi-layer capacitor structure. Such an element may in particular examples be a temperature dependent capacitor or temperature dependent resistor. However, any electrical component having the effect of operating on a drive voltage of current such as to modify such voltage or current as a function of temperature may also be used.

The passive compensation means may be further supported or boosted in examples by providing the active layer structure a backing which is pre-stressed and having a stiffness which reduces with temperature increase and vice versa. This can be used to counter negative or positive (respectively) thermal expansions of electroactive layers of the active layer structure. Hence mechanical property change of the backing layer with increasing temperature may further compensate for any residual thermal drift remaining.

The EAP material may be driven continuously in a fully actuated state as an idle or rest state of the device. Actuation displacement is achieved by moving the actuator to a less actuated state.

The example actuator structure described and claimed herein may be applied in any of a wide range of different applications. These include, but are not limited to: personal care devices (e.g. shavers, trimmers, skin care devices), oral healthcare devices (e.g. toothbrushes, tongue cleaners, mouth pieces, air floss devices), personal health devices (e.g. handheld devices, wearables), and medical devices (e.g. catheters, guide wires, CMUT probes or other devices).

Although in the detailed description herein above the construction and operation of devices and systems according to the invention have been described for EAPs, the invention may in fact be used for devices based on other kinds of responsive material, including other kinds of EAM material. Hence, unless indicated otherwise, the EAP materials hereinabove can be replaced with other responsive materials such as other EAM materials. Such other responsive materials are known in the art and the person skilled in the art will know where to find them and how to apply them.

Materials suitable for an EAP element are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:

Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to: acrylates, polyurethanes, silicones.

The sub-class conjugated polymers includes, but is not limited to: polypyrrole, poly-3, 4-ethylenedioxythiophene, poly(p-phenylene sulfide), polyanilines.

In all of these examples, additional passive layers may be provided for influencing the electrical and/or mechanical behavior of the EAP element in response to an applied electric field.

Each EAP element may be sandwiched between electrodes. The electrodes may be stretchable so that they follow the deformation of the EAP material. Materials suitable for the electrodes should be ultrasound-transmissive and include for instance thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS).

If the electrodes are arranged in a non-symmetric configuration, the imposed voltage can induce all kinds of deformations such as twisting, rolling, torsioning, turning, and non-symmetric bending deformation.

As discussed above, embodiments of the invention make use of a controller. The controller can be implemented in numerous ways, with software and/or hardware, to perform the various functions required. A processor is one example of a controller which employs one or more microprocessors that may be programmed using software (e.g., microcode) to perform the required functions. A controller may however be implemented with or without employing a processor, and also may be implemented as a combination of dedicated hardware to perform some functions and a processor (e.g., one or more programmed microprocessors and associated circuitry) to perform other functions.

Examples of controller components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media such as volatile and non-volatile computer memory such as RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor or controller.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An actuator structure (40) adapted to compensate for thermal variation in actuation displacement, the structure comprising:
an active layer structure (44) comprising one or more material layers (48), each including an electroactive material deformable in response to electrical stimulation;
a passive carrier layer structure (45) coupled to the active layer structure; and
a passive compensation means (46) arranged to modify a current or voltage of an electrical stimulus provided to the electroactive material of the active layer structure as a function of temperature, to thereby compensate for said thermal variation in actuation displacement, **characterized in that**
the passive compensation means comprises a multi-layer temperature-dependent capacitor structure, and wherein said passive carrier layer structure is adapted to form said capacitor structure.

2. An actuator structure (40) as claimed in claim 1, wherein said active layer structure (44) exhibits a thermal deformation as a function of temperature, and wherein the passive compensation means modifies said current or voltage as a function of temperature at a rate such as to cause a consequent variation in electrical deformation which counters said thermal deformation.

3. An actuator structure (40) as claimed in claim 1 or 2, wherein the multi-layer capacitor structure is arranged in electrical series with the electroactive material of the active layer structure (44).

4. An actuator structure as claimed in any of claims 1-3, wherein the multiple layers of the capacitor structure form a plurality of capacitors, preferably connected in parallel.

5. An actuator structure as claimed in claim 4, wherein at least two of the plurality of capacitors formed by the capacitor structure have differing capacitances.

6. An actuator structure (40) as claimed in claim 3, wherein the passive compensation means further includes a temperature-dependent resistor.

7. An actuator structure (40) as claimed in claim 1 or 2, wherein the passive compensation means is further provided by a material property of one or more of the material layers (48).

8. An actuator structure (40) as claimed in claim 7, wherein the material property is an electrical permittivity which varies as a function of temperature, and optionally wherein said electrical permittivity decreases as a function of increasing temperature.

9. An actuator structure (40) as claimed in any preceding claim, wherein the actuator structure includes a capacitance adjustment means arranged to supply a controllable bias voltage to the multi-layer capacitor structure for thereby adjusting a capacitance exhibited by the multi-layer capacitor structure in dependence upon the applied bias voltage.

10. An actuator structure (40) as claimed in claim 2 and claim 9, wherein the capacitance compensation means is configured to adjust the level of the supplied bias voltage such that the capacitance exhibited by the capacitor structure as a function of temperature modifies said current or voltage at a rate such as to cause a consequent variation in electrical deformation which counters the thermal variation is actuation displacement.

11. An actuator structure (40) as claimed in claim 10, further comprising a controller (62) which is adapted to provide a persistent electrical bias to the active layer structure (44) to stimulate partial deformation of the active layer structure.

12. An actuator structure (40) as claimed in any preceding claim, wherein the active layer structure (44) is configured to exhibit a bending bias in a first direction in the absence of electrical deformation or thermal deformation of the active layer structure, and is configured to exhibit a bending bias in an opposing direction upon electrical deformation or thermal expansion, and optionally a controller (62) which is adapted to provide a persistent electrical bias to the active layer structure to partially counter said bending bias in the first direction.

13. An actuator structure (40) as claimed in any preceding claim, wherein the carrier layer structure (44) comprises one or more pre-stressed material layers, and wherein the carrier layer structure exhibits an elasticity which varies positively with temperature, and optionally wherein at least the active layer structure exhibits a thermal expansion which varies negatively with temperature.

14. An actuation method comprising controlling electrical stimulation of an actuator structure (40), the actuator structure comprising
an active layer structure (44) comprising one or more material layers (48), each including an electroactive material deformable in response to electrical stimulation, and
a passive carrier layer structure (45) coupled to the active layer structure, and the method comprising:
providing electrical stimulation to the active layer structure, wherein a current or voltage of the electrical stimulation is pre-modified as a function of temperature by a passive compensation means (46) to thereby compensate for thermal variation in actuation displacement of the actuator structure, **characterized in that**
the passive compensation means comprises a multi-layer temperature-dependent capacitor structure, and wherein said passive carrier layer structure is adapted to form said capacitor structure.

15. An actuation method as claimed in claim 14, wherein the active layer structure (44) exhibits a thermal deformation as a function of temperature, and wherein said passive compensation means is adapted to modify said voltage or current as a function of temperature at a rate such as to cause a consequent variation in electrical deformation which counters the thermal deformation.

## Patentansprüche

1. Eine Aktorstruktur (40), die thermische Schwankungen der Betätigungsverschiebung kompensiert, wobei die Struktur Folgendes umfasst:
eine aktive Schichtstruktur (44) mit mit mindestens einer Materialschicht (48), die jeweils ein elektroaktives Material enthält, das sich bei einer elektrischen verformt;
eine passive Trägerschichtstruktur (45), die mit der aktiven Schichtstruktur verbunden ist; und
eine passive Kompensationsvorrichtung (46), die den Strom oder die Spannung eines elektrischen Impuls, der für das elektroaktive Material der aktiven Schichtstruktur bereitgestellt wird, als Funktion der Temperatur modifiziert, um auf diese Weise die thermische Schwankung der Betätigungsverschiebung zu kompensieren, und die sich dadurch auszeichnet, dass die passive Kompensationsvorrichtung eine mehrschichtige temperaturabhängige Kondensatorstruktur umfasst, und
wobei die passive Trägerschichtstruktur die Kondensatorstruktur bildet.

2. Eine Aktorstruktur (40) gemäß Anspruch 1, wobei die aktive Schichtstruktur (44) eine temperaturabhängige thermische Verformung aufweist, und wobei die passive Kompensationsvorrichtung den Strom oder die Spannung als Funktion der Temperatur mit einer Rate verändert, die eine Veränderung der elektrischen Verformung bewirkt, um der thermischen Verformung entgegenzuwirken.

3. Eine Aktorstruktur (40) gemäß Anspruch 1 oder 2, wobei die mehrschichtige Kondensatorstruktur mit dem elektroaktiven Material der aktiven Schichtstruktur (44) elektrisch in Reihe geschaltet ist.

4. Die Aktorstruktur gemäß einem der Ansprüche 1 bis 3, wobei die Schichten der Kondensatorstruktur eine mehrere Kondensatoren bilden, die vorzugsweise parallel geschaltet sind.

5. Eine Aktorstruktur gemäß Anspruch 4, wobei mindestens zwei der durch die Kondensatorstruktur gebildeten Kondensatoren unterschiedliche Kapazitäten aufweisen.

6. Eine Aktorstruktur (40) gemäß Anspruch 3, wobei die passive Kompensationsvorrichtung zudem einen temperaturabhängigen Widerstand aufweist.

7. Eine Aktorstruktur (40) gemäß Anspruch 1 oder 2, wobei die passive Kompensationsvorrichtung zudem im Rahmen der Materialeigenschaft mindestens einer der Materialschichten (48) bereitgestellt wird.

8. Eine Aktorstruktur (40) gemäß Anspruch 7, wobei es sich bei der Materialeigenschaft um eine elektrische Dielektrizitätskonstante handelt, die als Temperaturfunktion variiert, und wobei die elektrische Dielektrizitätskonstante optional abhängig von einer steigenden Temperatur abnimmt.

9. Eine Aktorstruktur (40) gemäß einem der vorhergehenden Ansprüche, wobei die Aktorstruktur eine Kapazitätseinstellungseinheit umfasst, die eine regelbare Vorspannung an die Mehrschichtkondensatorstruktur anzulegen, um eine Kapazität einzustellen, die die Mehrschichtkondensatorstruktur abhängig von der angelegten Vorspannung erfordert.

10. Eine Aktorstruktur (40) gemäß Anspruch 2 und 9, wobei die Kapazitätseinstellungseinheit den Pegel der angelegten Vorspannung so einstellt, dass die von der Kondensatorstruktur erforderte Kapazität als Temperaturfunktion den Strom oder die Spannung anhand einer Rate modifiziert, die eine sich hieraus ergebende Veränderung der elektrischen Verformung verursacht, die der thermischen Schwankung als Betätigungsverschiebung entgegenwirkt.

11. Eine Aktorstruktur (40) gemäß Anspruch 10, die zudem eine Steuerung (62) umfasst, die an die aktive Schichtstruktur (44) eine anhaltende elektrische Vorspannung anlegt, um eine teilweise Verformung der aktiven Schichtstruktur anzuregen.

12. Eine Aktorstruktur (40) gemäß einem der vorhergehenden Ansprüche, wobei die aktive Schichtstruktur (44) beim Fehlen einer elektrischen oder thermischen Verformung der aktiven Schichtstruktur eine Biegevorspannung in einer ersten Richtung und bei einer elektrischen Verformung oder thermischen Ausdehnung eine Biegevorspannung in der entgegengesetzten Richtung aufweist, und wobei diese optional eine Steuerung (62) umfasst, die an die aktive Schichtstruktur eine anhaltende elektrische Vorspannung anlegt, um der Biegevorspannung in der ersten Richtung teilweise entgegenzuwirken.

13. Eine Aktorstruktur (40) gemäß einem der vorhergehenden Ansprüche, wobei die Trägerschichtstruktur (44) mindestens eine vorgespannte Materialschicht umfasst, und wobei die Trägerschichtstruktur eine Elastizität aufweist, die positiv mit der Temperatur variiert, und wobei mindestens die aktive Schichtstruktur optional eine thermische Ausdehnung aufweist, die sich mit der Temperatur negativ verändert.

14. Eine Betätigungsmethode, die das Steuern des elektrischen Anregens einer Aktorstruktur (40) umfasst, wobei die Aktorstruktur Folgendes umfasst:
eine aktive Schichtstruktur (44) mit mit mindestens einer Materialschicht (48), die jeweils ein elektroaktives Material enthält, das sich bei einer elektrischen verformt, und
eine passive Trägerschichtstruktur (45), die mit der aktiven Schichtstruktur verbunden ist,
und wobei die Methode folgende Schritte umfasst:
Elektrisches Anregen der aktiven Schichtstruktur, wobei der Strom oder die Spannung für das elektrische Anregen als Temperaturfunktion mithilfe einer passiven Kompensationsvorrichtung (46) vorab verändert wird, um auf diese Weise die thermische Schwankung der Betätigungsverschiebung der Aktorstruktur zu kompensieren, und die sich dadurch auszeichnet, dass die passive Kompensationsvorrichtung eine mehrschichtige temperaturabhängige Kondensatorstruktur umfasst, und wobei die passive Trägerschichtstruktur die Kondensatorstruktur bildet.

15. Eine Betätigungsmethode gemäß Anspruch 14, wobei die aktive Schichtstruktur (44) eine temperaturabhängige thermische Verformung aufweist, und wobei die passive Kompensationsvorrichtung den Strom oder die Spannung als Funktion der Temperatur mit einer Rate verändert, die eine Veränderung der elektrischen Verformung bewirkt, um der thermischen Verformung entgegenzuwirken.

## Revendications

1. Structure d'actionneur (40) conçue pour compenser la variation thermique du déplacement d'actionnement, ladite structure comprenant :
une structure de couche active (44) comprenant au moins une couche de matière (48), chacune comprenant une matière électroactive déformable en réponse à une stimulation électrique ;
une structure de couche porteuse passive (45) couplée à la structure de couche active ; et
un moyen de compensation passive (46) conçu pour modifier un courant ou une tension d'un stimulus électrique fourni à la matière électroactive de la structure de couche active en fonction de la température, pour compenser ainsi ladite variation thermique du déplacement d'actionnement, **caractérisée en ce que** le moyen de compensation passive comprend une structure de condensateur multicouche dépendant de la température, et dans laquelle ladite structure de couche porteuse passive est conçue pour former ladite structure de condensateur.

2. Structure d'actionneur (40) selon la revendication 1, dans laquelle ladite structure de couche active (44) présente une déformation thermique en fonction de la température, et dans laquelle le moyen de compensation passive modifie ledit courant ou ladite tension en fonction de la température à une vitesse telle qu'elle provoque une variation consécutive de la déformation électrique, laquelle contre ladite déformation thermique.

3. Structure d'actionneur (40) selon la revendication 1 ou 2, dans lequel la structure de condensateur multicouche est agencée électriquement en série avec la matière électroactive de la structure de couche active (44).

4. Structure d'actionneur selon l'une quelconque des revendications 1 à 3, dans laquelle les multiples couches de la structure de condensateur forment une pluralité de condensateurs, de préférence connectés en parallèle.

5. Structure d'actionneur selon la revendication 4, dans laquelle au moins deux condensateurs de la pluralité de condensateurs formés par la structure de condensateur présentent des capacités différentes.

6. Structure d'actionneur (40) selon la revendication 3, dans laquelle le moyen de compensation passive comprend en outre une résistance dépendant de la température.

7. Structure d'actionneur (40) selon la revendication 1 ou 2, dans laquelle le moyen de compensation passive est en outre fourni par une propriété de matière de l'au moins une des couches de matière (48).

8. Structure d'actionneur (40) selon la revendication 7, dans laquelle la propriété de matière est une permittivité électrique, laquelle varie en fonction de la température, et éventuellement dans laquelle ladite permittivité électrique diminue en fonction de l'augmentation de la température.

9. Structure d'actionneur (40) selon l'une quelconque des revendications précédentes, dans laquelle la structure d'actionneur comprend un moyen d'ajustement de la capacité conçu pour fournir une tension de polarisation commandable à la structure de condensateur multicouche pour ajuster ainsi une capacité présentée par la structure de condensateur multicouche en fonction de la tension de polarisation appliquée.

10. Structure d'actionneur (40) selon la revendication 2 et la revendication 9, dans laquelle le moyen de compensation de capacité est conçu pour ajuster le niveau de la tension de polarisation fournie de telle sorte que la capacité présentée par la structure de condensateur en fonction de la température modifie ledit courant ou ladite tension à une vitesse telle qu'elle provoque une variation consécutive de la déformation électrique, laquelle compte la variation thermique est le déplacement d'actionnement.

11. Structure d'actionneur (40) selon la revendication 10, comprenant en outre un dispositif de commande (62), lequel est conçu pour fournir une polarisation électrique persistante à la structure de couche active (44) pour stimuler une déformation partielle de la structure de couche active.

12. Structure d'actionneur (40) selon l'une quelconque des revendications précédentes, dans laquelle la structure de couche active (44) est conçue pour présenter une polarisation de flexion dans une première direction en l'absence de déformation électrique ou de déformation thermique de la structure de couche active, et est conçue pour présenter une polarisation de flexion dans une direction opposée lors d'une déformation électrique ou une dilatation thermique, et éventuellement un dispositif de commande (62), lequel est conçu pour fournir une polarisation électrique persistante à la structure de couche active pour contrer partiellement ladite polarisation de flexion dans la première direction.

13. Structure d'actionneur (40) selon l'une quelconque des revendications précédentes, dans laquelle la structure de couche de support (44) comprend au moins une couche de matière précontrainte, et dans laquelle la structure de couche de support présente une élasticité, laquelle varie positivement avec la température, et éventuellement dans lequel au moins la structure de couche active présente une dilatation thermique, laquelle varie négativement avec la température.

14. Procédé d'actionnement comprenant la commande de la stimulation électrique d'une structure d'actionneur (40), la structure d'actionneur comprenant
une structure de couche active (44) comprenant au moins une couche de matière (48), chacune comprenant une matière électroactive déformable en réponse à une stimulation électrique, et
une structure de couche porteuse passive (45) accouplée à la structure de couche active,
et ledit procédé comprenant:
la fourniture d'une stimulation électrique à la structure de couche active, dans lequel un courant ou une tension de la stimulation électrique est pré-modifié en fonction de la température à l'aide d'un moyen de compensation passive (46) pour compenser ainsi la variation thermique du déplacement d'actionnement de la structure d'actionneur,
**caractérisé en ce que**
le moyen de compensation passive comprend une structure de condensateur multicouche dépendante de la température, et dans lequel ladite structure de couche porteuse passive est conçue pour former ladite structure de condensateur.

15. Procédé d'actionnement selon la revendication 14, dans lequel la structure de couche active (44) présente une déformation thermique en fonction de la température, et dans lequel ledit moyen de compensation passive est conçu pour modifier ladite tension ou ledit courant en fonction de la température à une vitesse telle qu'elle provoque une variation consécutive de la déformation électrique, laquelle contre la déformation thermique.
